# EUROPEAN PATENT APPLICATION

(11) **EP 4 459 004 A1**
(43) Date of publication of application: **06.11.2024**
(21) Application number: 23892918.6
(22) Date of filing: 09.03.2023
(51) Int. Cl.: C23C 16/44, C23C 16/505, B08B 7/00

(54) **METHOD FOR CLEANING PROCESS CHAMBER, AND APPLICATION THEREOF**

(30) Priority: 24.11.2022 CN 202211482170
(71) Applicant: Suzhou Maxwell Technologies Co., Ltd., Suzhou, Jiangsu 215200 (CN); Suzhou Maizheng Technology Co. Ltd, Suzhou, Jiangsu 215200 (CN)
(72) Inventor: QU, Qingyuan, Suzhou, Jiangsu 215200 (CN); HE, Xueyong, Suzhou, Jiangsu 215200 (CN); ZHOU, Jian, Suzhou, Jiangsu 215200 (CN); WEN, Ercheng, Suzhou, Jiangsu 215200 (CN); FANG, Xianfei, Suzhou, Jiangsu 215200 (CN); WANG, Dengzhi, Suzhou, Jiangsu 215200 (CN)
(74) Representative: Meyer-Dulheuer MD Legal Patentanwälte PartG mbB
(86) International application number: PCT/CN2023/080573
(87) International publication number: WO 2024/108808

(57) **Abstract**

The present application discloses a method for cleaning a process chamber and an application thereof. The method for cleaning a process chamber includes: (a) turning on a remote plasma system, exciting a clean-process gas into plasma, and supplying remote plasma to the process chamber; (b) after operation of the remote plasma system reaches a stable state, turning on a radio-frequency power supply system in the process chamber, re-exciting and enhancing the remote plasma positioned in the process chamber by the radio-frequency power supply system, and using both the remote plasma system and the radio-frequency power supply system for jointly acting and cleaning the process chamber during a period of cleaning time; (c) when the cleaning of the process chamber is completed, firstly turning off the radio-frequency power supply system in the process chamber; and (d) then turning off the remote plasma system.

## Description

### TECHNICAL FIELD

The present application belongs to the technical field of vacuum deposition apparatus, and particularly relates to a method for cleaning a process chamber and an application thereof.

### BACKGROUND

At present, in large-scale plasma deposition apparatus, such as chemical vapor deposition (CVD) apparatus, plasma enhanced chemical vapor deposition (PECVD) apparatus, atomic layer deposition (ALD) apparatus, plasma enhanced atomic layer deposition (PEALD) apparatus or other etching, deposition apparatus, the cleaning of the interior of a vacuum chamber and a tray for holding sample is necessary operation for ensuring the cleanliness of the interior of the vacuum chamber.

In the related art, the cleaning of a vacuum deposition chamber is generally achieved by using a remote plasma system (RPS) for exciting a cleaning gas into plasma state, delivering the plasma into the process chamber through gas line, and chemically reacting the plasma with film layers or particulate impurities in the chamber. In addition, sometimes the RPS is not used, while a flat capacitive coupled discharge structure of the deposition apparatus, such as the PECVD apparatus itself is utilized for achieving a cleaning effect by changing the process gas, for example, a corrosive cleaning gas such as NF₃, and converting an original deposition process to etching cleaning. However, when the plasma is generated by excitation of the remote plasma system for cleaning the process chamber, during transportation, a recombination phenomenon of remote plasma occurs before the remote plasma reaches the process chamber, so that the overall cleaning effect is reduced. However, the conventional flat capacitive coupled discharge structure apparatus has the problems of low etching rate, narrow etching range or incomplete coverage in etching cleaning. Therefore, there is a need for an improved method for cleaning a process chamber in vacuum deposition apparatus in the related art.

### SUMMARY

In view of the above problems, the present disclosure aims at solving at least one of the technical problems in the related art at least to some extent. To this end, the present disclosure provides a method for cleaning a process chamber and an application thereof, which may alleviate the problems of low etching rate, narrow etching range or incomplete coverage existing in current cleaning methods, and may be conducive to the improvement of the cleaning etching efficiency and rate.

In order to solve the above technical problems, the present application is achieved as follows:

An example of the present application provides a method for cleaning a process chamber, the method including the steps of:
(a) introducing the clean-process gas into a remote plasma system, turning on the remote plasma system, exciting the gas into plasma, and supplying remote plasma to the process chamber;
(b) after operation of the remote plasma system reaches a stable state, turning on a radio-frequency power supply system in the process chamber, re-exciting and enhancing the remote plasma positioned in the process chamber by the radio-frequency power supply system, and cleaning the process chamber by utilizing the re-excited and enhanced plasma; and
   using both the remote plasma system and the radio-frequency power supply system for jointly acting and cleaning the process chamber during a period of cleaning time;
(c) when the cleaning of the process chamber is completed, firstly turning off the radio-frequency power supply system in the process chamber; and
(d) after the radio-frequency power supply system is turned off, turning off the remote plasma system.

In addition, the method for cleaning a process chamber according to the present application may further have the following additional technical features:

in some embodiments, the clean-process gas includes purge gas and cleaning gas, and the step (a) includes:
(a1) pre-treating the inner chamber of the remote plasma system, the gas line, and the process chamber, the pre-treatment including purging the inner chamber of the remote plasma system, the gas line, and the process chamber by utilizing the purge gas, and then turning on the remote plasma system; and
(a2) after the remote plasma system is turned on, introducing the cleaning gas, and supplying the plasma generated by excitation of the remote plasma system to the process chamber.

In some embodiments, the purge gas includes at least one of Ar, He, N₂, or H₂.

In some embodiments, before the radio-frequency power supply system in the process chamber is turned on, a flow rate of the cleaning gas in the clean-process gas is gradually increased to achieve a certain ratio of the cleaning gas to the purge gas, wherein the ratio of the flow rate of the cleaning gas to a flow rate of the purge gas is gradually increased or stepwise increased.

In some embodiments, the cleaning gas includes a corrosive gas, the corrosive gas including at least one of NF₃, CF₄, SF₆, C₂F₆, F₂, C₃F₈, CHF₃, HF, Cl₂, or HCl.

In some embodiments, the remote plasma system includes an inductive coil coupled discharge structure, and the remote plasma system adopts an alternating-current power supply having a frequency of 100 KHz to 13.56 MHz.

In some embodiments, in the step (b), when the remote plasma system is turned on for 5-150 s and an operation state of the remote plasma system is stable, the radio-frequency power supply system is turned on.

In some embodiments, operation parameters of the radio-frequency power supply system include:
a frequency range of a radio-frequency power supply being 2 MHz to 100 MHz; and/or
a power range of the radio-frequency power supply being 500 W to 90,000 W; and/or
a discharge spacing range of the radio-frequency power supply being 5 mm to 50 mm; and/or
an operation gas pressure during cleaning of the process chamber being 0.01 Torr to 10 Torr.

In some embodiments, the step (d) further includes:
after the radio-frequency power supply system is turned off, and before the remote plasma system is turned off, only introducing the purge gas, exciting the purge gas by utilizing the remote plasma system to generate plasma, and purging the process chamber by utilizing the plasma.

The present application further provides an application of the method for cleaning a process chamber as described above in vacuum deposition process apparatus, wherein the vacuum deposition process apparatus includes chemical vapor deposition apparatus or atomic layer deposition apparatus.

The implementation of the technical solution of the present disclosure has at least the following beneficial effects.

In the example of the present application, according to the provided method for cleaning a process chamber, a combination of the remote plasma system and the radio-frequency power supply system in the process chamber is adopted for cleaning, and both the remote plasma system and the radio-frequency power supply system are used for jointly acting and cleaning the process chamber during a period of cleaning time. After plasma generated by excitation of the remote plasma system is delivered to the process chamber, the plasma is re-excited and enhanced by the radio-frequency power supply system, so as to increase an input power, etching rate is improved, and the plasma power is increased, so that more gas molecules are in an excited state, ionization is enhanced, plasma density is increased, the whole process chamber of the plasma deposition apparatus may be fully covered, and then the cleaning etching efficiency and rate may be greatly improved. Meanwhile, in the method of the present disclosure, the turning on and turning off sequence or time limit of the remote plasma system and the radio-frequency power supply system is defined, thereby ensuring the cleaning quality, shortening the cleaning time, providing a sufficient amount of plasma, enhancing the cleaning etching effect, and reducing or avoiding damage to devices in the chamber.

Additional aspects and advantages of the present application will be set forth in part in the following description, will partially become apparent from the description, or may be learned by practice of the present application.

### BRIEF DESCRIPTION OF DRAWINGS

FIG. 1 is a schematic flow diagram of a method for cleaning a process chamber provided by some exemplary embodiments of the present application;
FIG. 2 is another schematic flow diagram of the method for cleaning the process chamber provided by some exemplary embodiments of the present application; and
FIG. 3 is a schematic structural diagram of semiconductor process apparatus provided by some exemplary embodiments of the present application.

### Reference numerals:

100-radio-frequency power supply system; 200-remote plasma system; 300-upper electrode; 400-tray; and 500-heating plate.

### DETAILED DESCRIPTION OF THE EMBODIMENTS

The technical solutions in examples of the present application will be described clearly and completely below in conjunction with the accompanying drawings in the examples of the present application. Obviously, some, but not all examples of the present application are described. Based on the examples in the present application, all the other examples obtained by those of ordinary skill in the art without involving any inventive effort shall fall within the protection scope of the present application.

In the related art, for the cleaning of a process chamber in plasma deposition apparatus, a single remote plasma source (RPS) or a single radio-frequency power supply is usually used for cleaning etching, and there are certain disadvantages, for example, when a single remote plasma source (RPS) system or a radio-frequency power supply flat discharge system is used, a range of etching for an interior of a vacuum chamber is narrow, and a large-scale plasma deposition chamber may not be completely covered, and during transportation, a recombination phenomenon of remote plasma occurs before the remote plasma reaches the process chamber, so that the overall cleaning effect is reduced; alternatively, when a single plasma excitation mode is used, the consumption of the cleaning gas is increased, and the cleaning effect is poor. In addition, when the plasma is excited in-situ by utilizing the radio-frequency power supply system for cleaning, there are problems such as low etching rate, narrow etching range or incomplete coverage. Therefore, cleaning methods in the prior art need to be further improved.

In view of the foregoing, the technical solution of an example of the present application provides a method for cleaning a process chamber and an application thereof. The technical solution of the example of the present application may alleviate the problems such as low etching rate, narrow etching range or incomplete coverage existing in etching cleaning of large-scale plasma deposition apparatus. See below for the description of a specific technical solution.

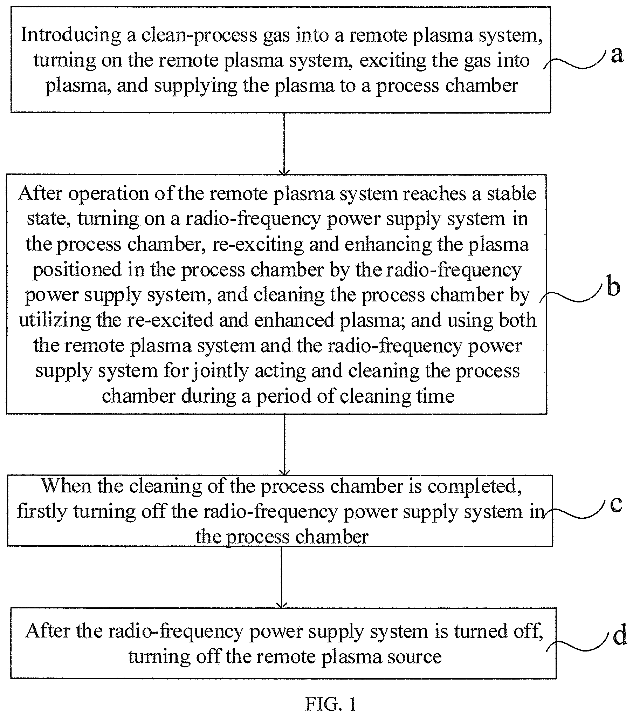

Referring to FIG. 1 to FIG. 3, in some examples, provided is a method for cleaning a process chamber, the method including the steps of:
(a) the clean-process gas is introduced into a remote plasma system, the remote plasma system is turned on, the gas is excited into plasma, and remote plasma is supplied to the process chamber;
(b) after operation of the remote plasma system reaches a stable state, a radio-frequency power supply system in the process chamber is turned on, the remote plasma positioned in the process chamber is re-excited and enhanced by the radio-frequency power supply system, and the process chamber is cleaned by utilizing the re-excited and enhanced plasma; and
   both the remote plasma system and the radio-frequency power supply system are used for jointly acting and cleaning the process chamber during a period of cleaning time;
(c) when the cleaning of the process chamber is completed, firstly the radio-frequency power supply system in the process chamber is turned off; and
(d) after the radio-frequency power supply system is turned off, the remote plasma system is turned off.

In the prior art, the process chamber is cleaned only by plasma generated by excitation of the remote plasma system, and during transportation, a recombination phenomenon of remote plasma occurs before the remote plasma reaches the process chamber, namely the number of dissociated particles reaching the process chamber is less than the number of dissociated particles generated by excitation of the remote plasma system. Therefore, in the cleaning method provided by this example, a combination of the remote plasma source and the radio-frequency power supply is adopted for cleaning, and simultaneously a combination of the remote plasma and the radio-frequency in-situ excited plasma is adopted for cleaning the process chamber, namely, both the remote plasma system and the radio-frequency power supply system are used for jointly acting and cleaning the process chamber during a period of cleaning time. After the plasma generated by excitation of the remote plasma system is delivered to the process chamber, the plasma is re-excited and enhanced by the radio-frequency power supply system, so as to increase a radio-frequency power supply, input power is increased, etching rate is improved, and plasma power is increased on the basis of the RPS in cleaning etching, so that more gas molecules are in an excited state, ionization is enhanced, plasma density is increased, the whole process chamber of the plasma deposition apparatus may be fully covered, and then the cleaning etching efficiency and rate may be greatly improved.

Compared with the existing method for cleaning by firstly adopting the remote plasma and then adopting the in-situ plasma, the method of the present disclosure may further improve the cleaning etching efficiency and rate, shorten the cleaning time, and have a better cleaning effect, with simple process and convenience in operation. That is, compared with the existing remote plasma cleaning and radio-frequency plasma cleaning methods, according to the present disclosure, the plasma positioned in the process chamber is re-excited and enhanced by utilizing the radio-frequency power supply system, and the process chamber is cleaned by utilizing the re-excited and enhanced plasma, so that the gas between an upper electrode and a lower electrode in the process chamber may be fully dissociated to generate a plasma discharge effect, and a dissociation rate of the gas is greatly improved, thereby enhancing the etching effect and improving the cleaning effect of the whole chamber; moreover, both the remote plasma system and the radio-frequency power supply system are used for jointly acting and cleaning the process chamber during a period of cleaning time, and active particles in the plasma react with pollutants to generate volatile substances, thereby achieving the purpose of removing surface stains. In order to ensure the cleaning quality and shorten the cleaning time, the plasma is continuously introduced by the remote plasma system, so that a sufficient amount of plasma may be provided, thereby improving the cleaning efficiency and enhancing the cleaning effect.

Meanwhile, in the method of the present disclosure, the turning on and turning off sequence or time limit of the remote plasma system and the radio-frequency power supply system is defined, and specifically, firstly the remote plasma system is turned on, and after operation of the remote plasma system reaches a stable state, the radio-frequency power supply system is turned on, so that the turning on time of the radio-frequency power supply system is later than the turning on time of the RPS for the purpose of enabling the radio-frequency power supply to operate in a more stable state when the plasma delivered by the RPS system into the process chamber has the optimal cleaning effect, thereby being conducive to the enhancement of cleaning etching effect, and improvement of cleaning etching efficiency. Further, after the cleaning is finished, firstly the radio-frequency power supply system in the process chamber is turned off, and then the RPS system is turned off, so as to prevent the radio-frequency power and matching box from being easily damaged due to the change of gas atmosphere in the chamber and the instability of parameters of the radio-frequency power supply after the RPS system is turned off, or prevent the occurrence of a phenomenon of damage to accessories in the chamber due to abnormal discharge in the chamber, with good safety and stability.

It should be noted that in this example, by turning on the radio-frequency power supply system in the process chamber after the operation of the remote plasma system reaches a stable state, not only the radio-frequency power supply system may operate in a more stable state to reduce or avoid a phenomenon of instability of the radio-frequency power supply, but also the plasma delivered by the remote plasma system into the process chamber has the optimal cleaning effect, thereby improving the cleaning effect of the remote plasma, and greatly enhancing the cleaning etching effect. Optionally, the radio-frequency power supply system includes a radio-frequency power and matching box. The specific structure and operating principle of the radio-frequency power supply system may refer to the prior art, and are not limited in this example of the present disclosure.

It should be noted that the cleaning method of this example may be applied in the fields of photovoltaic production equipment or semiconductor device production equipment, for example, applied in large-scale plasma vacuum deposition apparatus for cleaning the process chamber in the vacuum deposition apparatus. For example, the vacuum deposition apparatus may be chemical vapor deposition (CVD) apparatus, atomic layer deposition (ALD) apparatus and the like, and is not limited in this example. Further, the CVD apparatus may include plasma enhanced chemical vapor deposition (PECVD) apparatus or atmospheric pressure chemical vapor deposition apparatus and the like, and the ALD apparatus may include plasma enhanced atomic layer deposition (PEALD) apparatus and the like. Depending on the type of deposition apparatus, optionally, the process chamber may be used for performing CVD, or for performing PECVD, or for performing ALD and the like. Optionally, the process chamber is a plasma reaction chamber.

For the sake of brevity, by mainly taking the PECVD deposition apparatus as the deposition apparatus for example, the method for cleaning the process chamber of the present disclosure will be described in detail below. However, it should be understood that when the method is applied to other related apparatus, there is the same or similar principle which is not described in detail herein.

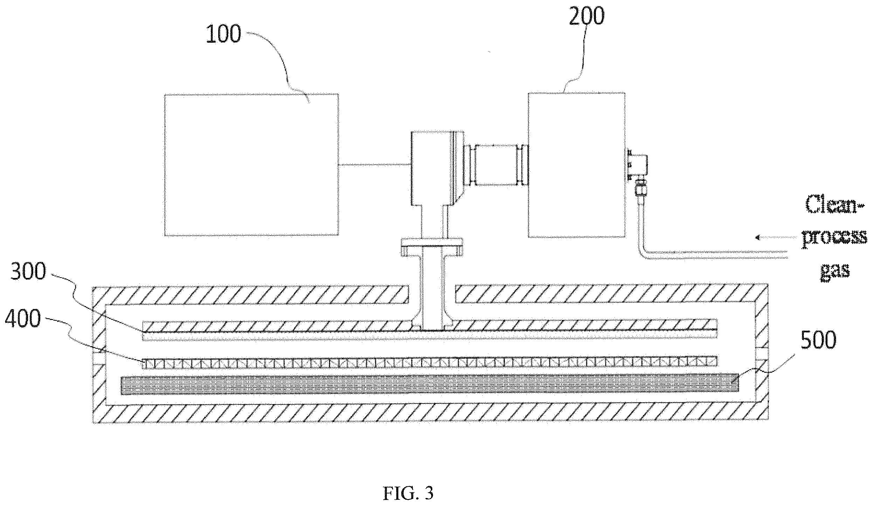

As shown in FIG. 3, the PECVD deposition apparatus includes a process chamber, a radio-frequency power supply system 100, and a remote plasma system 200, wherein the radio-frequency power supply system 100 is disposed in the process chamber, the remote plasma system 200 is connected with the process chamber, or the remote plasma system 200 is coupled to the process chamber and the radio-frequency power supply system 100.

Optionally, the PECVD deposition apparatus further includes an upper electrode 300, a tray 400, and a heating plate 500, wherein the tray 400 or the heating plate 500 may serve as a lower electrode, and the upper electrode 300, the tray 400 and the heating plate 500 are all disposed in the process chamber. Optionally, the upper electrode 300 may include a showerhead for introducing and distributing the process gas and the clean-process gas. Alternatively, the upper electrode 300 may include a conductive plate, and the process gas may be introduced in another manner.

Optionally, the radio-frequency power supply system 100 generates and outputs an RF power to one of the upper electrode 300 and the lower electrode, and the other of the upper electrode 300 and the lower electrode may be DC grounded, AC grounded, or floats.

Optionally, an input end of the remote plasma system 200 is connected to gas line, an output end of the remote plasma system 200 is connected to the process chamber, and the gas line may be used for delivering the cleaning gas or purge gas.

Referring to the PECVD deposition apparatus described above, the method for cleaning the process chamber according to the example of the present disclosure will be described in detail below.

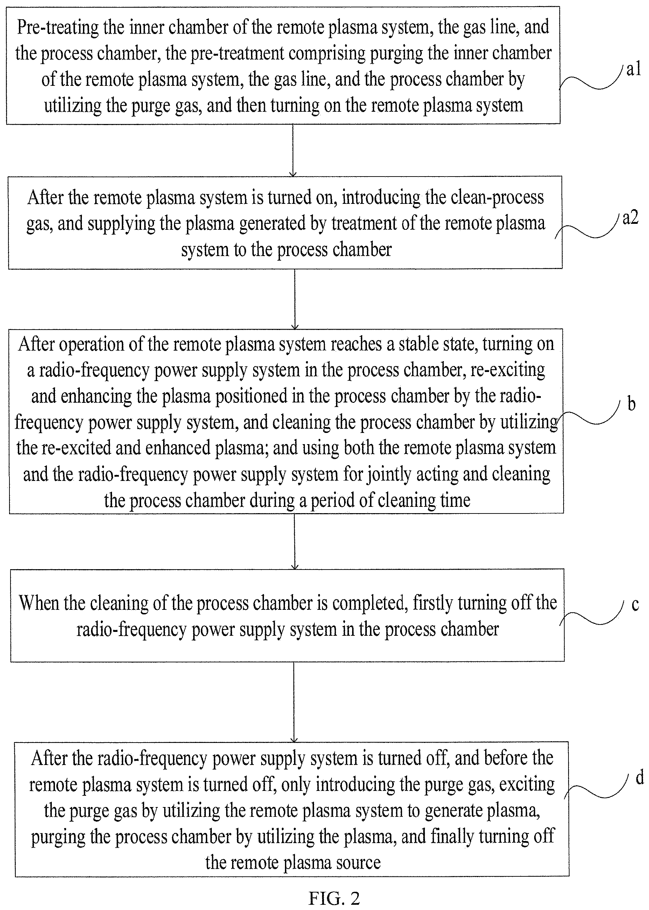

In some specific examples, as shown in FIG. 1 or FIG. 2, the method for cleaning the process chamber includes the steps of:
(a) the clean-process gas is introduced into a remote plasma system, the remote plasma system is turned on, the gas is excited into plasma, and remote plasma is supplied to the process chamber.

Specifically, the (a) includes:
(a1) pre-treatment is performed on an inner chamber of the remote plasma system, the gas line, and the process chamber, the pre-treatment including purging the inner chamber of the remote plasma system, the gas line, and the process chamber by utilizing the purge gas, and then the remote plasma system is turned on.

Optionally, the purge gas includes at least one of Ar, He, N₂, or H₂, for example, the purge gas may be Ar, He, N₂, or H₂ and the like. Preferably, Ar is adopted as the purge gas, so that the sources are wide, the cost is relatively low, and a better purging effect may be obtained.

In addition, in other embodiments, other types of gases may also be adopted as purge gases under the condition of meeting actual process requirements, and are not specifically enumerated herein.

Optionally, the remote plasma system is connected to the gas line, and the purge gas is supplied into the process chamber by the gas line and the remote plasma system which is not in operation. The process chamber is sufficiently purged by providing the purge gas such as Ar into the gas line and enabling the purge gas to enter the process chamber via the gas line and the remote plasma system which is not in operation.

Before etching cleaning of the process chamber, the chamber needs to be sufficiently purged, generally Ar is taken as the purge gas, and the purge gas may flow into the process chamber by the remote plasma system which is not in operation. In this manner, the gas in the process chamber is sufficiently replaced to reduce or avoid the impact on the subsequent cleaning etching process, so as to ensure the etching cleaning effect.

(a2) after the remote plasma system is turned on, the cleaning gas is introduced, and the plasma generated by excitation of the remote plasma system is supplied to the process chamber.

The cleaning gas is supplied to the remote plasma system, for example, the cleaning gas is supplied to the remote plasma system by the gas line; and the remote plasma system is turned on to excite the cleaning gas (also referred to as cleaning gas) flowing therethrough into a plasma state, and the plasma cleaning gas enters the chamber, namely RPS plasma is supplied to the process chamber.

Optionally, when the remote plasma system is turned on, the purge gas is present in the gas line; and in a process of cleaning the process chamber, the cleaning gas is gradually input into the gas line.

Optionally, in the process of cleaning the process chamber, a flow rate of the cleaning gas is gradually increased, and a the ratio of the flow rate of the cleaning gas to a flow rate of the purge gas is gradually increased or stepwise increased.

In this example, before the radio-frequency power supply system in the process chamber is turned on, the flow rate of the cleaning gas in the clean-process gas is gradually increased to achieve a certain ratio of the cleaning gas to the purge gas, wherein the the ratio of the flow rate of the cleaning gas to the flow rate of the purge gas is gradually increased or stepwise increased. When the remote plasma system is turned on, the purge gas needs to be utilized for excitation, and if the purge gas is directly switched into the cleaning gas, the cleaning gas introduced into the remote plasma system may not be excited and may be likely to damage the apparatus.

In this example, when the remote plasma system is turned on, the purge gas such as Ar is present in the gas line. For example, before the remote plasma system is turned on, Ar is delivered into the process chamber by the gas line and the remote plasma system which is not in operation for purging, and after the purging is completed, at least a part of the Ar may remain in the gas line, so that Ar is present in the gas line when the remote plasma is turned on. Further, in a cleaning process, the cleaning gas such as a corrosive gas containing an F element may be slowly supplied into the gas line, and as the cleaning process continues, a the ratio of the flow rate of the cleaning gas such as the corrosive gas containing the F element to the flow rate of the purge gas is gradually increased or stepwise increased, and after a certain time, the gas line is completely filled with the cleaning gas. In this manner, by retaining a part of Ar in an initial stage of the turning on of the RPS system, the ionization stability of the cleaning gas such as the corrosive gas containing the F element may be improved, and the loss of the cleaning gas may be reduced or avoided, with safety, reliability and good stability.

Optionally, the cleaning gas includes an F-containing corrosive gas, and the F-containing corrosive gas includes at least one of NF₃, CF₄, SF₆, C₂F₆, F₂, C₃F₈, CHF₃, and HF; in addition, the cleaning gas is not limited to the F-containing corrosive gas, but other types of corrosive gases such as Cl₂ and HCl may also be adopted. Illustratively, the corrosive gas may be NF₃, CF₄, SF₆, C₂F₆, F₂, C₃F₈, CHF₃, HF, Cl₂, HCl, or a mixture of any two or more of the foregoing gases. By adopting the above corrosive gases, specially the F-containing corrosive gas, as the cleaning gas, the sources are wide, the cost is relatively low, and a better cleaning result may be obtained.

Optionally, the remote plasma system includes a remote plasma source having an inductive coil coupled discharge structure. Optionally, the remote plasma system adopts an alternating-current power supply having a frequency of 100 KHz to 13.56 MHz. That is, the RPS adopts an inductive coil coupled discharge structure, and the RPS power supply adopts an alternating-current power supply having a frequency of 100 KHz to 13.56 MHz.

(b) after operation of the remote plasma system reaches a stable state, a radio-frequency power supply system in the process chamber is turned on, in-situ plasma is excited in the process chamber, the plasma positioned in the process chamber is re-excited and enhanced by the radio-frequency power supply system, and the process chamber is cleaned by utilizing the re-excited and enhanced plasma; and both the remote plasma system and the radio-frequency power supply system are used for jointly acting and cleaning the process chamber during a period of cleaning time.

In this example, before the cleaning process, a suitable operating pressure, flow rate of the gas, cleaning time, power of the radio-frequency power supply, discharge spacing, and delay time of the turning on of the radio-frequency power supply after the RPS system is turned on need be set according to the situation.

Optionally, in the step (b), when the remote plasma system is turned on for 5-150 s (for example, may be turned on for 5 s, 6 s, 7 s, 8 s, 9 s, 10 s, 30 s, 50 s, 100 s, 120 s, 150 s and the like) and an operation state of the remote plasma system is stable, the radio-frequency power supply system is turned on. Whether the remote plasma system reaches a stable operating state may be determined according to the turning on time of the remote plasma system, for example, after the remote plasma system is turned on for 5 s to 150 s, the remote plasma system is considered to reach a stable operating state. Of course, in other embodiments, other ways may be adopted for determining whether the remote plasma system reaches a stable operating state.

When the remote plasma system reaches a stable state, the radio-frequency power supply system is turned on, remote plasma may be supplied to the process chamber by the remote plasma system, the radio-frequency power supply is positioned in the process chamber, and the remote plasma is re-excited and enhanced by the radio-frequency power supply system after being delivered into the process chamber, so that the process chamber is cleaned by utilizing the remote plasma system and the radio-frequency power supply system simultaneously. In this manner, not only does the radio-frequency power supply system operate in a more stable state, thereby reducing or avoiding the phenomenon of instability of the radio-frequency power supply, but also the plasma delivered by the remote plasma system into the process chamber has the optimal cleaning effect, thereby greatly enhancing the cleaning etching effect.

Optionally, a frequency range of the radio-frequency power supply is 2 MHz to 100 MHz. Optionally, the frequency range of the radio-frequency power supply is 5 MHz to 80 MHz. Optionally, the frequency range of the radio-frequency power supply is 10 MHz to 50 MHz. In some examples, the radio-frequency power supply may operate at a frequency of 2 MHz, 5 MHz, 10 MHz, 13.56 MHz, 20 MHz, 28.5 MHz, 43.2 MHz, 50 MHz, 75 MHz, 80 MHz, 100 MHz and the like, but other frequencies may also be used.

Optionally, a power range of the radio-frequency power supply is 500 W to 90,000 W. Optionally, the power of the radio-frequency power supply is 800 W to 60,000 W. Optionally, the power of the radio-frequency power supply is 1,000 W to 20,000 W. For example, the power of the radio-frequency power supply may be 500 W, 800 W, 1,000 W, 2,000 W, 5,000 W, 8,000 W, 10,000 W, 20,000 W, 50,000 W, 80,000 W and the like, but other RF power levels may also be used.

Optionally, a discharge spacing range of the radio-frequency power supply is 5 mm to 50 mm. Optionally, the discharge spacing of the radio-frequency power supply is 8 mm to 30 mm. Optionally, the discharge spacing of the radio-frequency power supply is 10 mm to 20 mm. In some examples, the discharge spacing of the radio-frequency power supply may be 5 mm, 8 mm, 10 mm, 15 mm, 20 mm, 25 mm, 30 mm, 40 mm, 50 mm and the like, but other discharge spacings may also be used.

Optionally, an operation gas pressure during cleaning of the process chamber is 0.01 Torr to 10 Torr. Optionally, the operation gas pressure during cleaning of the process chamber is 0.1 Torr to 8 Torr. Optionally, the operation gas pressure during cleaning of the process chamber is 0.5 Torr to 5.5 Torr. For example, the operation gas pressure during cleaning of the process chamber is 0.01 Torr, 0.1 Torr, 0.3 Torr, 0.5 Torr, 1 Torr, 2 Torr, 5 Torr, 8 Torr, 10 Torr and the like.

Thus, based on the above setting, after the plasma source is stable, the radio-frequency power and the matching box are turned on, so that a gas between an upper electrode and a lower electrode may be fully dissociated to generate a plasma discharge effect, and a dissociation rate of the gas is greatly improved, thereby enhancing the etching effect and improving the cleaning effect of the whole chamber; wherein the two cleaning methods are used simultaneously. The active particles in the plasma react with pollutants to generate volatile substances, thereby achieving the purpose of removing surface stains. In order to ensure the cleaning quality and shorten the cleaning time, the plasma is continuously introduced by the RPS system, so that a sufficient amount of plasma may be provided.

It should be noted that the radio-frequency power and the matching box must be turned on after the operation of the RPS system reaches a stable state. The turning on time of the radio-frequency power and the matching box is later than the turning on time of the RPS for the purpose of enabling the radio-frequency power supply to operate in a more stable state when the plasma delivered by the RPS system into the chamber has the optimal cleaning effect, thereby being conducive to the enhancement of the cleaning effect and enabling the whole system to operate more stably.

Optionally, a cleaning object further includes a tray which may be used for holding silicon wafers during deposition. That is, when the process chamber is cleaned, not only may the environment inside the process chamber or inner walls of the process chamber be cleaned, but also the components such as the tray in the process chamber may be cleaned.

Optionally, the distance between the upper electrode and the lower electrode, the power of the radio-frequency power and the matching box the flow rate of the cleaning gas, and the gas pressure in the chamber may be adjusted to control the distribution range and intensity of plasma glow, and the temperature of the whole process chamber may be controlled by adjusting the temperature, so as to achieve different etching effects.

Optionally, when the tray holding the sample is in the process chamber, the tray is grounded, and the tray is the lower electrode, may be in contact with the heating plate, and may be suspended. The heating plate is the lower electrode when the tray is not in the process chamber.
(c) When the cleaning of the process chamber is completed, firstly the radio-frequency power supply system in the process chamber is turned off.
(d) After the radio-frequency power supply system is turned off, and before the remote plasma system is turned off, only the purge gas is introduced, the purge gas is excited by utilizing the remote plasma system to generate plasma, the process chamber is purged by utilizing the plasma, and finally the remote plasma system is turned off.

Optionally, the purge gas may be a purge gas such as Ar as previously described.

In this example, after the process chamber is cleaned, the chamber also needs to be purged sufficiently, for example, by adopting Ar plasma or Ar. In this manner, continued purging after cleaning facilitates the removal of corrosive particles from the chamber and prevents the subsequent deposition process from being affected.

It should be noted that when the etching cleaning is completed, firstly the radio-frequency power supply in the process chamber needs to be turned off, and then the RPS system is turned off. After the RPS system is shut down, the cleaning process stops after continuing to introduce Ar for a period of time. On the one hand, during operation, the RPS system should not be turned off firstly before the radio-frequency system is turned off, so as to prevent the radio-frequency power and the matching box from being easily damaged due to the change of a gas atmosphere in the chamber and the instability of parameters of the radio-frequency power supply after the RPS system is turned off, or prevent the damage to accessories in the chamber due to abnormal discharge in the chamber. On the other hand, after the RPS system is turned off, the introduction of Ar is continued for a period of time, for the purpose of purging the chamber sufficiently by adopting Ar plasma or Ar to remove residual corrosive particles and avoid affecting the subsequent deposition process.

Based on the same inventive concept, an example of the present application further provides an application of the method for cleaning the process chamber as described above in vacuum deposition process apparatus, wherein the vacuum deposition process apparatus includes chemical vapor deposition apparatus or atomic layer deposition apparatus.

It should be understood that the application of the method for cleaning the process chamber in vacuum deposition process apparatus in this example is based on the same inventive concept as the method for cleaning the process chamber described above, and thus has at least all the features and advantages of the method for cleaning the process chamber, which will not be described in detail herein.

Unspecified parts of the description of the present disclosure are known to those skilled in the art. Finally, it should be noted that the above examples are merely illustrative of the technical solutions of the present disclosure, rather than limiting it; although the present disclosure has been described in detail with reference to the foregoing examples, those skilled in the art will appreciate that the technical solutions disclosed in the above examples may still be modified, or some of the technical features thereof can be replaced by equivalents; and such modifications and replacements do not allow the corresponding technical solutions to depart from the spirit and scope of the technical solutions of various examples of the present disclosure in nature.

## Claims

1. A method for cleaning a process chamber, the method comprising the steps of:
(a) introducing a clean-process gas into a remote plasma system, turning on the remote plasma system, exciting the gas into plasma, and supplying remote plasma to the process chamber;
(b) after operation of the remote plasma system reaches a stable state, turning on a radio-frequency power supply system in the process chamber, re-exciting and enhancing the remote plasma positioned in the process chamber by the radio-frequency power supply system, and cleaning the process chamber by utilizing the re-excited and enhanced plasma; and
using both the remote plasma system and the radio-frequency power supply system for jointly acting and cleaning the process chamber during a period of cleaning time;
(c) when the cleaning of the process chamber is completed, firstly turning off the radio-frequency power supply system in the process chamber; and
(d) after the radio-frequency power supply system is turned off, turning off the remote plasma system.

2. The method for cleaning a process chamber according to claim 1, wherein the clean-process gas comprises purge gas and cleaning gas, and the step (a) comprises:
(a1) pre-treating an inner chamber of the remote plasma system, a gas line and the process chamber, the pre-treatment comprising purging the inner chamber of the remote plasma system, the gas line and the process chamber by utilizing the purge gas, and then turning on the remote plasma system; and
(a2) after the remote plasma system is turned on, introducing the cleaning gas, and supplying the plasma generated by excitation of the remote plasma system to the process chamber.

3. The method for cleaning a process chamber according to claim 2, wherein the purge gas comprises at least one of Ar, He, N₂, or H₂.

4. The method for cleaning a process chamber according to claim 2, wherein before the radio-frequency power supply system in the process chamber is turned on, a flow rate of the cleaning gas in the clean-process gas is gradually increased so as to achieve a certain ratio of the cleaning gas to the purge gas, wherein the ratio of the flow rate of the cleaning gas to a flow rate of the purge gas is gradually increased or stepwise increased.

5. The method for cleaning a process chamber according to claim 2, wherein the cleaning gas comprises a corrosive gas, the corrosive gas comprises at least one of NF₃, CF₄, SF₆, C₂F₆, F₂, C₃F₈, CHF₃, HF, Cl₂, or HCl.

6. The method for cleaning a process chamber according to claim 1, wherein the remote plasma system comprises an inductive coil coupled discharge structure, and the remote plasma system adopts an alternating-current power supply having a frequency of 100 KHz to 13.56 MHz.

7. The method for cleaning a process chamber according to claim 1, wherein in the step (b), when the remote plasma system is turned on for 5 - 150 seconds and the operation state of the remote plasma system is stable, the radio-frequency power supply system is turned on.

8. The method for cleaning a process chamber according to any one of claims 1-7, wherein operation parameters of the radio-frequency power supply system comprise:
a frequency range of a radio-frequency power supply being 2 MHz to 100 MHz; and/or
a power range of the radio-frequency power supply being 500 W to 90,000 W; and/or
a discharge spacing range of the radio-frequency power supply being 5 mm to 50 mm; and/or
an operation gas pressure during cleaning of the process chamber being 0.01 Torr to 10 Torr.

9. The method for cleaning a process chamber according to any one of claims 1-7, wherein the step (d) further comprises:
after the radio-frequency power supply system is turned off and before the remote plasma system is turned off, only introducing the purge gas, exciting the purge gas by utilizing the remote plasma system to generate plasma, and purging the process chamber by utilizing the plasma.

10. An application of the method for cleaning a process chamber according to any one of claims 1 - 9 in vacuum deposition process apparatus, wherein the vacuum deposition process apparatus comprises chemical vapor deposition apparatus or atomic layer deposition apparatus.
